# DEMANDE DE BREVET EUROPEEN

(11) **EP 4 035 773 A1**
(43) Date de publication de la demande: **03.08.2022**
(21) Numéro de dépôt: 22153711.1
(22) Date de dépôt: 27.01.2022
(51) Int. Cl.: B01J 31/16, B01J 20/22, C23C 16/455, C23C 16/56, C07F 1/00, C23C 16/40, C07F 3/00, C07F 5/00, C07F 15/02, C07F 15/06, C07F 19/00

(54) **PROCÉDÉ DE FORMATION D'UN RÉSEAU MÉTALLO-ORGANIQUE**

(30) Priorité: 28.01.2021 FR 2100820
(71) Demandeur: Commissariat à l'Énergie Atomique et aux Énergies Alternatives, 75015 Paris (FR); Centre National de la Recherche Scientifique, 75016 Paris (FR); École Supérieure de Chimie, Physique, Électronique, 69100 Villeurbanne (FR); Université Claude Bernard Lyon 1, 69100 Villeurbanne (FR)
(72) Inventeur: PERROT, Virginie, 38054 Grenoble Cedex 9 (FR); JOUSSEAUME, Vincent, 38054 Grenoble Cedex 9 (FR); QUADRELLI, Elsje, 69003 Lyon (FR); ROUSSEY, Arthur, 38054 Grenoble Cedex 09 (FR)
(74) Mandataire: Germain Maureau

(57) **Abrégé**

Procédé de formation d'un réseau métallo-organique (5) comprenant une étape de fourniture d'un substrat (10) ; une unique étape de formation (20) d'une seule couche d'oxyde métallique formée sur le substrat (10), ladite couche d'oxyde métallique étant transformée en tout ou partie en réseau métallo-organique (5) par mise en œuvre successive d'une pluralité de cycles de réaction (P) ; chaque cycle de réaction (P) de la pluralité de cycles de réaction comportant: une étape de traitement avec au moins un ligand (P1) ; une étape de traitement avec au moins un additif (P2) ; les cycles de réaction (P) étant mis en œuvre au moins deux fois de manière à former le réseau métallo-organique sur le substrat (10).

## Description

### DOMAINE TECHNIQUE

La présente invention concerne un procédé de formation d'un réseau métallo-organique sur un substrat.

L'invention porte également sur un réseau métallo-organique obtenu par un tel procédé.

### ETAT DE LA TECHNIQUE ANTERIEURE

Les réseaux métallo-organiques poreux, appelés en anglais « MOF » pour Metal Organic Framework sont des matériaux hybrides cristallins créés à partir de molécules organiques appelées ligands et de molécules inorganiques, comme des sels d'ions métalliques, formant une structure en une, deux ou trois dimensions. Ces matériaux, de par leur structure régulière, présentent une porosité dont le diamètre de pore est de l'ordre de l'angström à la centaine d'angström avec des valeurs de surface spécifique extrêmement élevées et des maximums atteignant 7000 m².g⁻¹.

Ces caractéristiques, couplées à leur résistance mécanique, thermique et/ou chimique, les rendent particulièrement attractifs comme matériaux adsorbants ou couche sensible à intégrer dans des dispositifs de détection ou capture de gaz ou de liquide.

Les réseaux métallo-organiques poreux sont généralement synthétisés sous forme de poudre par des procédés en solution, malheureusement leur intégration dans des dispositifs, et notamment dans les dispositifs de taille micrométrique, est difficile.

Il existe donc un besoin pour obtenir un procédé de fabrication de réseaux métallo-organique poreux compatible avec les standards de la microélectronique.

### EXPOSE DE L'INVENTION

La présente invention a pour but de répondre à tout ou partie des problèmes présentés ci-avant.

Notamment, un but est de fournir une solution répondant à tout ou partie des objectifs suivants :
- obtenir un procédé permettant d'être compatible avec la microélectronique ;
- obtenir un réseau métallo-organique aux propriétés structurelles acceptables.

Ce but peut être atteint grâce à la mise en œuvre d'un procédé de formation d'un réseau métallo-organique comprenant :
- une étape de fourniture d'un substrat ;
- une unique étape de formation d'une seule couche d'oxyde métallique formée sur le substrat, ladite couche d'oxyde métallique étant transformée en tout ou partie en réseau métallo-organique par mise en œuvre successive d'une pluralité de cycles de réaction P ;
   chaque cycle de réaction P de la pluralité de cycles de réaction comportant :
   une étape de traitement avec au moins un ligand ;
   une étape de traitement avec au moins un additif ;
   les cycles de réaction P étant mis en œuvre au moins deux fois de manière à former le réseau métallo-organique sur le substrat.

Certains aspects préférés mais non limitatifs de ce procédé sont les suivants.

Dans une mise en œuvre du procédé, le cycle de réaction P comprend une étape de purge P0 consistant en une mise sous vide et/ou une fourniture de gaz neutre ; l'étape de purge P0 étant effectuée avant et/ou après l'étape de traitement avec un ligand.

Dans une mise en œuvre du procédé, l'étape de traitement avec un additif se déroule au moins en partie pendant l'étape de traitement avec un ligand.

Dans une mise en œuvre du procédé, l'oxyde métallique est un oxyde de zinc, un oxyde de cobalt, un oxyde de cuivre, un oxyde de fer ou un oxyde d'indium.

Dans une mise en œuvre du procédé, les cycles de réaction P sont répétés jusqu'à ce que la couche d'oxyde métallique soit entièrement transformée en réseau métallo-organique.

Dans une mise en œuvre du procédé, l'additif est de l'eau ou un alcool ou un polyol ou une combinaison de ces additifs ou un réactif destiné à former au moins l'un de ces additifs lors du cycle de réaction P.

Dans une mise en œuvre du procédé, le substrat et/ou ledit ligand et/ou ledit additif, est maintenu à une température comprise entre 80°C et 180°C durant le cycle de réaction P.

Dans une mise en œuvre du procédé, l'étape de traitement avec un ligand, ledit au moins un ligand est en phase liquide ou en phase vapeur ; et, dans l'étape de traitement avec un additif, ledit additif est en phase liquide ou en phase vapeur.

Dans une mise en œuvre du procédé, le ligand est en phase vapeur et pendant l'étape de traitement avec un ligand, ledit au moins un ligand est mélangé à au moins un gaz porteur appartenant au groupe comprenant le diazote, l'hélium et l'argon.

Dans une mise en œuvre du procédé, ledit au moins un ligand est à une pression partielle comprise entre 0,1 mbar et 50 mbar. De préférence, ledit au moins un ligand est à une pression partielle comprise entre 14 mbar et 35 mbar.

Dans une mise en œuvre du procédé, l'étape de traitement avec un additif, ledit au moins un additif est en phase vapeur et est mélangé à au moins un gaz porteur appartenant au groupe comprenant le diazote, l'hélium et l'argon.

Dans une mise en œuvre du procédé, ledit au moins un additif est à une pression partielle comprise entre 1 mbar et 900 mbar, plus particulièrement entre 200 mbar et 600 mbar, et, de préférence, supérieure à 400 mbar.

Dans une mise en œuvre du procédé, le procédé comprend une étape d'activation dans laquelle des pores ouverts du réseau métallo-organique sont rendus accessibles pour l'adsorption de molécules par un traitement thermique effectué sous vide dynamique, sous un flux de gaz neutre, ou par immersion dans un solvant.

Dans une mise en œuvre du procédé, la couche d'oxyde métallique, avant la mise en œuvre des cycles de réaction P, a une épaisseur supérieure à 18 nanomètres et est composée d'oxyde de zinc ; le ligand utilisé dans l'étape de traitement par un ligand est du 2-méthylimidazole ; l'additif utilisé dans l'étape de traitement par un additif est de l'eau, le cycle de réaction P est répété au moins quinze fois ; et l'étape d'activation consiste en un traitement thermique jusqu'à 280°C sous diazote.

Selon une mise en œuvre du procédé, l'ensemble du procédé de formation ne met en œuvre aucune autre couche d'oxyde métallo-organique que l'unique couche métallo-organique formée sur le substrat.

Un autre aspect de l'invention est un réseau métallo-organique formé par la mise en œuvre d'un tel procédé, le réseau métallo-organique formé sur le substrat se présentant sous la forme d'une seule couche monolithique ne présentant pas de strates. De préférence, ce réseau métallo-organique a une épaisseur supérieure à 250 nm

### BREVE DESCRIPTION DES DESSINS

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels:
La figure 1 illustre le procédé selon l'invention dans lequel chaque cycle de réaction comprend une étape de traitement avec un ligand et une étape de traitement avec un additif.
La figure 2 illustre un exemple de procédé selon l'invention dans lequel au moins l'un des cycles de la pluralité de cycles de réaction comprend une étape de purge.
La figure 3 illustre l'épaisseur d'un réseau métallo-organique poreux de type ZIF-8 obtenue par un exemple de procédé selon l'invention en fonction de la température du substrat et en fonction du nombre de cycles de réaction.
La figure 4 illustre l'épaisseur d'un réseau métallo-organique poreux de type ZIF-8 obtenue par un exemple de procédé selon l'invention où, dans l'étape de traitement avec un ligand, le ligand est en phase vapeur à 100°C et accompagné P1b, ou non P1a, d'un gaz porteur, en fonction du nombre de cycles de réaction.
La figure 5 illustre un exemple du cycle A d'un procédé d'obtention d'une couche d'oxyde métallique de l'étape de formation 20.
La figure 6 illustre une vue en coupe d'un substrat recouvert d'une couche d'oxyde métallique se transformant progressivement en réseau métallo-organique lors de la mise en œuvre successive des cycles de réaction.
La figure 7 illustre l'épaisseur d'un réseau métallo-organique de type ZIF-8 obtenue en fonction de la pression partielle de l'additif, dans ce cas de l'eau en phase vapeur, lors de la mise en œuvre d'un cycle de réaction du procédé selon l'invention.

### EXPOSE DETAILLE DE MODES DE REALISATION PARTICULIERS

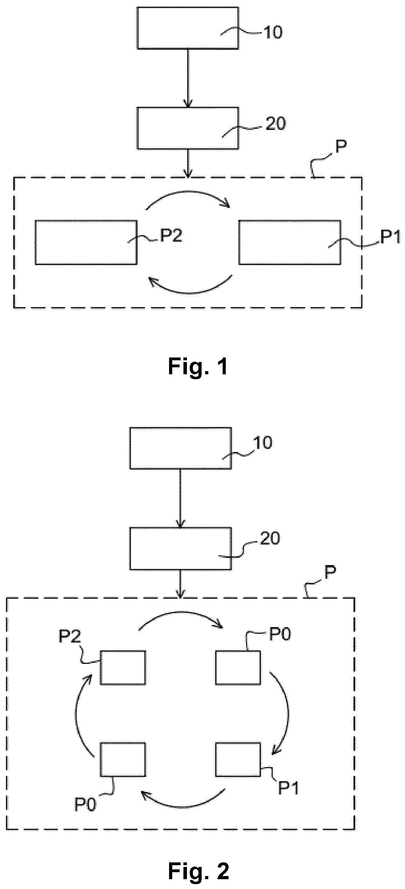

Sur les figures 1 à 6 annexées et dans la suite de la description, des éléments identiques ou similaires en terme fonctionnel sont repérés par les même références.

De plus, les différents éléments ne sont pas représentés à l'échelle de manière à privilégier la clarté des figures pour en faciliter la compréhension.

Par ailleurs, les différents modes ou exemples et variantes ne sont pas exclusifs les uns des autres et peuvent, au contraire, être combinés entre eux.

Dans la suite de la description, sauf indication contraire, les termes « sensiblement », « environ », « globalement » et « de l'ordre de » signifient « à 10 % près ».

L'invention porte en premier lieu sur un procédé de formation d'un réseau métallo-organique de manière à former des composés connus de la personne du métier sous les appellations ZIF-8, ZIF-72, ZIF-61, ZIF-67, ZIF-71, ZIF-94, MAF-6, MAF-28, MOF-5, H-KUST, UiO-66(-NH2) ou Cu-TPA.

Comme illustré sur les figures 1 et 2, le procédé comprend tout d'abord une étape dite de fourniture d'un substrat 10. Ce substrat 10 présente au moins une face de dépôt. Le substrat 10 peut être plan ou tridimensionnel, la face de dépôt peut donc être également plane ou tridimensionnelle. Le substrat 10 peut ainsi par exemple comprendre des piliers notamment en silicium, des systèmes électromécaniques notamment micrométriques ou nanométriques ou bien encore être une microbalance à quartz. Le substrat 10 peut comprendre un isolant, un semiconducteur, un conducteur électrique, ou une architecture plane mêlant ces trois éléments comme un circuit de capteur ou de microprocesseur.

Comme illustré sur les figures 1, 2 et 5, le procédé comprend également une unique étape dite de formation 20 dans laquelle une seule couche d'oxyde métallique est formée sur la face de dépôt, autrement dit sur le substrat 10. Cette étape peut être mise en œuvre suivant les connaissances générales de la personne du métier. Les termes « seule couche » signifient de manière équivalente que la couche d'oxyde métallique, formée elle-même potentiellement d'une multitude de sous-couches atomiques, lors de l'étape de formation 20, est obtenue uniquement lors de cette étape dite de formation 20 et n'est plus formée/déposée ensuite lors des cycles de réaction décrits ci-après. Ceci diffère des méthodes classiques mettant en œuvre une formation de réseau métallo-organique poreux par reproduction de cycles, où chaque cycle implique la formation d'une nouvelle couche d'oxyde métallique et d'une exposition à un ligand.

L'avantage du dépôt d'une seule couche d'oxyde métallique pour l'obtention de l'ensemble du réseau métallo-organique 5 est de pouvoir changer d'équipement à l'issue du dépôt de la couche d'oxyde métallique qu'une seule fois, ce qui permet un gain de temps. Il est en outre également possible d'enchaîner toutes les étapes du procédé dans un même équipement ce qui est d'autant plus avantageux.

Un avantage supplémentaire du procédé, selon l'invention, réside également dans la formation d'un réseau métallo-organique pouvant atteindre des épaisseurs supérieures à 250 nanomètres. Un avantage supplémentaire est que le réseau métallo-organique obtenu est poreux et cristallisé. Il ne nécessite donc pas de traitement supplémentaire de cristallisation, contrairement à des méthodes utilisant le dépôt par couche moléculaire appelé en anglais « Molecular Layer Deposition ». Un avantage supplémentaire est que le coût du procédé est plus faible.

La couche d'oxyde métallique est créée à partir de métal par exemple sous forme d'une couche mince ou de particules à base préférentiellement de Zn, Co, Cu, Fe ou encore de In. Selon une autre réalisation, la couche d'oxyde métallique pourrait être créée à partir de métal par exemple sous forme d'une couche mince ou de particules à base de Mn, Li, B, Cd, Hg, Pr, Mg, Al, Zr, Hf, Ti ou encore Ta.

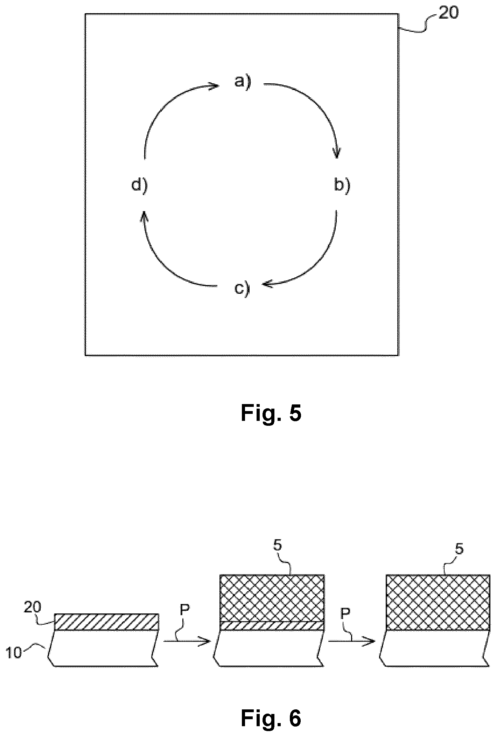

Selon un exemple de réalisation illustré sur la figure 5, dans l'étape de formation 20, la couche d'oxyde métallique est formée sur le substrat 10 par la méthode de dépôt par couche atomique appelée en anglais « Atomic Layer Deposition ». Plus précisément, dans cet exemple, pour former la couche d'oxyde métallique sur le substrat 10, une première partie du procédé d'obtention de la couche d'oxyde métallique consiste à réaliser un cycle « A » plusieurs fois, sous une pression inférieure à un torr, pour former des sous-couches atomiques qui font croître la couche d'oxyde métallique. Pour cela, une première étape facultative du cycle A consiste à chauffer le substrat 10 entre 30°C et 360°C, de préférence entre 90°C et 360°C et plus préférentiellement encore à environ 150°C. Cette étape permet d'améliorer la croissance. Ensuite, le cycle A comprend une étape a) d'injection d'un précurseur. Le précurseur est par exemple un précurseur organométallique ou un précurseur halogéné. Par exemple, pour obtenir une couche à base de Zinc, le précurseur organométallique préféré est le diethylzinc, mais d'autres précurseurs sont possibles : diméthylzinc ou du zinc acétate ou pour les précurseurs halogénés le dichlorure de Zinc (ZnCl₂). L'injection du précurseur dure entre 1 ms et 30 minutes, de préférence 25 ms. Le cycle A, comprend, en suivant, une étape de purge b) pour éliminer les précurseurs en excès ou les sous-produits de réaction. La purge est réalisée par mise sous vide ou par injection d'un gaz neutre. À l'issue de la purge, le cycle A comprend une étape c) d'injection d'un agent réactif comme de l'eau, de l'ozone ou encore de l'oxygène sous forme d'un plasma. L'injection de l'agent réactif dure entre 1 ms et 30 minutes et de préférence 25 ms. L'injection de l'agent réactif est suivie éventuellement d'une seconde purge d). Cette seconde purge permet d'éliminer l'agent réactif en excès ou les sous-produits de réaction. Pour obtenir par exemple du ZnO, le précurseur organométallique peut être du diethylzinc. Pour le ZnO, la mise en œuvre du cycle A est réalisée environ 300 fois pour obtenir une couche d'oxyde métallique de sensiblement 50 nanomètres. En fonction du type de réseau métallo-organique à obtenir, la personne du métier modifiera la nature de la couche d'oxyde métallique, le précurseur utilisé et le nombre de cycle réalisé.

La personne du métier pourra modifier les paramètres de formation de la couche d'oxyde métallique pour que celle-ci puisse être dense c'est-à-dire non poreuse ou bien au contraire poreuse.

D'autres méthodes peuvent être utilisées par la personne du métier pour obtenir la couche d'oxyde métallique comme par exemple le dépôt en phase vapeur (PVD, CVD) ou encore le dépôt par vaporisation, aussi appelé en anglais « spray-coating », ou encore par technique sol-gel.

Dans une variante de réalisation, il est possible de prévoir que le substrat comprenne une couche d'accroche formant la face de dépôt du substrat 10. Cette couche d'accroche est déposée préalablement au cycle A. La couche d'accroche permet d'éviter, plus tard, la délamination du réseau métallo-organique par rapport au substrat 10 dans le cas où on consommerait toute la couche d'oxyde métallique.

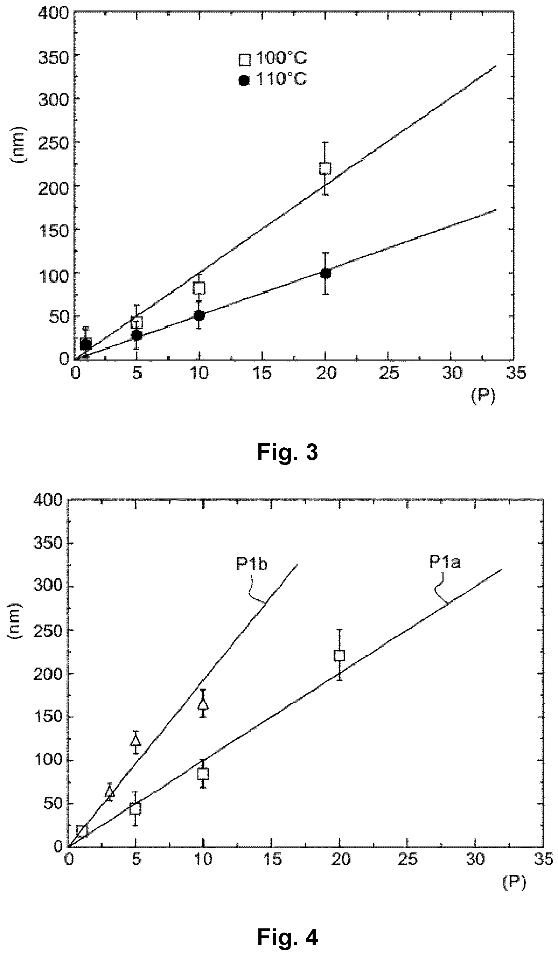

Comme illustré sur les figures 1, 2 et 6, le procédé comprend en outre une pluralité de cycles de réaction P. Les cycles de réaction P de la pluralité sont mis en œuvre successivement. En d'autres termes, une fois la couche d'oxyde métallique formée, le réseau métallo-organique est obtenu en totalité par la mise en œuvre de cycles de réaction P, successivement, sans avoir recours à une quelconque autre couche d'oxyde métallique entre les cycles de réaction P. La couche d'oxyde métallique est ainsi transformée progressivement à chaque cycle de réaction P en tout ou partie du réseau métallo-organique 5 pour former in fine le réseau métallo-organique 5. Autrement dit, le procédé comprend au moins deux mises en œuvre d'un cycle de réaction P. De préférence, le cycle de réaction P est mis en œuvre au minimum 15 fois, par exemple 20 fois (cf. figure 3). Tant que la couche d'oxyde métallique n'est pas entièrement transformée en réseau métallo-organique, le cycle de réaction P peut être reconduit, jusqu'à obtenir le rendement maximal en consommant toute la couche d'oxyde métallique. Autrement dit, le cycle de réaction P peut être répété jusqu'à atteindre la consommation totale de la couche d'oxyde métallique. L'épaisseur du réseau métallo-organique augmente à chaque itération du cycle de réaction P. Par le procédé de l'invention, les parties successives du réseau métallo-organique, qui se forment au fur et à mesure de la transformation de la couche d'oxyde métallique à chaque itération du cycle de réaction P, ne forment pas des strates sans interaction chimique entre elles. A la fin du procédé, les différentes parties du réseau métallo-organique ne sont ainsi pas distinctes les unes des autres et le réseau métallo-organique ainsi formé est monolithique sans interfaces internes c'est-à-dire sans strates. Le cycle de réaction P est obligatoirement mis en œuvre au moins deux fois de façon successive. Par exemple, dans le cas de l'obtention de ZIF-8, en partant d'une couche d'oxyde métallique d'épaisseur sensiblement égale à 18 nanomètres, on obtient un réseau métallo-organique de 250 nanomètres d'épaisseur. En conclusion, l'élément limitant la réaction ayant lieu durant le cycle P est l'épaisseur initiale de la couche d'oxyde métallique. Plus la couche d'oxyde métallique est importante, plus une couche de réseau métallo organique épaisse peut être obtenue à la fin du procédé de l'invention.

Avantageusement, le réseau métallo-organique ainsi formé par le procédé de l'invention est constitué d'une couche monolithique, c'est-à-dire de manière équivalente sans strates contenant des résidus d'oxyde métallique ou sans strates créées par des étapes répétées de dépôt de couche d'oxyde métallique sur des couches intermédiaires de réseau métallo-organique. Le réseau métallo-organique obtenu par le procédé de l'invention est ainsi plus homogène que celui obtenu par les méthodes précitées mettant en œuvre des cycles où chaque cycle implique la formation d'une nouvelle couche d'oxyde métallique sur une couche intermédiaire du réseau métallo-organique. En d'autres termes, l'ensemble du procédé de formation ne met en œuvre aucune autre couche d'oxyde métallo-organique que la seule couche métallo-organique formée sur le substrat 10 à l'étape de formation 20.

Chaque cycle comprend au moins une étape de traitement avec un ligand P1 dans laquelle au moins un ligand est amené en contact de tout ou partie de la couche d'oxyde métallique. Ainsi, suivant la porosité ou la nature de la couche d'oxyde métallique, le ligand peut réagir avec la couche d'oxyde métallique en surface et/ou dans l'épaisseur de la couche d'oxyde métallique. La couche d'oxyde métallique est alors transformée en partie, à chaque phase de la réaction P, en une portion additionnelle du réseau métallo-organique à former.

À titre d'exemples, les réseaux métallo-organique poreux ZIF-8, ZIF-72, ZIF-61, MAF-6 et ZIF-94 peuvent être obtenus à partir d'oxyde de zinc comme couche d'oxyde métallique et respectivement des ligands 2-méthylimidazole, 4,5-dichloroimidazole, 1H-imidazole et 2-méthylimidazole, 2-ethylimidazole et 4-methylimidazole-5-carbaldehyde. Pour obtenir un réseau métallo-organique MAF-28, un ligand comme le 3-(2-Pyridyl)-5-(4-pyridyl)-1,2,4-triazole peuvent être utilisés. Pour former le réseau métallo-organique ZIF-71, le ligand 4,5-dichloroimidazole peut également être utilisé.

Il résulte de ce qui a été décrit ci-dessus que le réseau métallo-organique poreux ZIF-61 peut être obtenu à partir d'oxyde de zinc comme couche d'oxyde métallique et d'un mélange de ligands 1H-imidazole et 2-méthylimidazole. En outre, il est aussi possible d'obtenir des réseaux métallo-organique poreux ZIF-60 et ZIF-62 à partir d'oxyde de zinc comme couche d'oxyde métallique et d'un mélange de ligands 1H-imidazole et 2-méthylimidazole.

Ainsi, il est possible que chaque cycle de réaction comprenne l'utilisation de plusieurs ligands mélangés en fonction du réseau métallo-organique 5 à obtenir. Autrement dit, chaque cycle de réaction peut par exemple être tel que l'étape de traitement P1 est une étape de traitement avec au moins deux ligands (i.e. deux ligands ou plus) de sorte que lesdits au moins deux ligands sont mélangés en vue de l'obtention du réseau métallo-organique 5.

Un réseau métallo-organique ZIF-67 peut être également obtenu à partir d'oxyde de Cobalt CoOx et du ligand 2-méthylimidazole.

Un réseau métallo-organique peut être également obtenu à partir d'oxyde de Cuivre CuO avec de l'acide fumarique comme ligand.

Dans tous les cas, le ligand peut être introduit sous forme liquide ou sous forme vapeur. Lorsque ledit au moins un ligand est sous forme vapeur, il peut par exemple être fourni à une pression partielle comprise entre sensiblement 0,1 mbar et 50 mbar notamment entre 1 et 30 mbar et pendant un temps de réaction allant de 0,1 secondes à 30 minutes et notamment pendant moins de 10 minutes. Une pression partielle minimale de 1.10⁻⁵ mbar peut être également envisagée. Pour l'obtention du ZIF-8, le ligand utilisé est 2-méthylimidazole, sa pression partielle est de 25 mbar à 150° et il est injecté à chaque cycle de réaction P avec un temps de réaction de 5 minutes environ.

De préférence, ledit au moins un ligand en phase vapeur (c'est-à-dire sous forme vapeur) est à une pression partielle comprise entre 14 mbar et 35 mbar.

La température du substrat 10 ainsi que celle de la couche d'oxyde métallique et/ou du réseau métallo-organique en cours de formation et/ou dudit au moins un ligand pendant l'étape P1 peut être comprise et/ou maintenue au minimum à 20°C, de préférence entre 80°C et 180°C et notamment à environ 100°C ou 110°C. La température d'un réservoir dans lequel le ligand est placé peut être plus élevée que dans l'enceinte de réaction où le substrat 10 est placé. Cela permet de favoriser le transport du ligand et l'absorption par le substrat et/ou la couche d'oxyde. Dans un exemple, le réservoir de ligand est à une température comprise entre 140 et 160°C.

Pendant l'étape de traitement avec un ligand P1, ledit au moins un ligand peut par exemple être mélangé à au moins un gaz porteur. Comme illustré sur la figure 4, dans le cas P1b, un gaz porteur tel que le diazote, l'hélium ou l'argon est utilisé. La pression partielle du gaz porteur peut être comprise entre 0,1 mbar et 900 mbar et plus particulièrement autour de 150 mbar.

Le cycle P comprend également une étape dite de traitement avec un additif P2 dans laquelle au moins un additif est en contact avec la couche d'oxyde métallique ou avec une portion additionnelle du réseau métallo-organique obtenue à l'issue de l'étape de traitement avec le ligand P1.

En particulier, l'additif participe à la synthèse du réseau métallo-organique 5. Ainsi l'additif, au sens de la présente description, est un réactif qui favorise in fine la transformation en tout ou partie de la couche d'oxyde métallique en réseau métallo-organique 5. Notamment, la présence de l'additif dans le cycle de réaction P concerné permet de favoriser, en particulier en formant des groupements OH, la transformation d'oxyde métallique issu de la couche d'oxyde métallique en vue de former le réseau métallo-organique 5. Ceci est notamment le cas lorsque la couche d'oxyde métallique est en ZnO et que le réseau métallo-organique 5 à former est un ZIF comme le ZIF-8 ou autre notamment en fonction du ligand utilisé. Notamment, la présence de l'additif permet à la réaction (c'est-à-dire la transformation de la couche d'oxyde métallique en tout ou partie en réseau métallo-organique 5) d'être cyclée à un même taux de croissance à chaque cycle de la pluralité de cycles de réaction P.

Ledit additif est par exemple de l'eau ou un alcool comme de l'éthanol, du méthanol, un diol ou un polyol ou une combinaison de ces éléments ou encore un produit d'une réaction précédente destiné à former un de ces éléments dans la chambre de réaction. Par exemple, dans le cadre de la mise en œuvre du procédé selon l'invention pour fabriquer un ZIF-8, l'additif utilisé est de l'eau.

L'additif peut être sous forme vapeur ou liquide.

Lorsque l'additif est sous forme vapeur, il peut être injecté à une pression partielle comprise entre par exemple 1 mbar et 900 mbar et plus particulièrement à entre 200 et 600 mbar, de préférence sensiblement égale à 400 mbar. L'injection de l'additif peut durer pendant un temps compris entre 0,1s et 30 minutes et notamment moins de 5 minutes. L'additif peut également être mélangé à au moins un gaz porteur comme le diazote, l'hélium ou l'Argon.

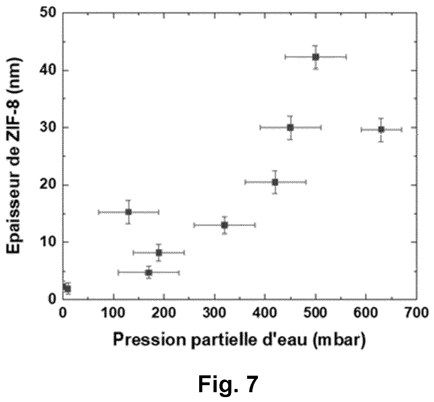

De préférence, tout en restant compatible avec les bornes supérieures des gammes données ci-avant, la pression partielle de l'additif en phase vapeur (c'est-à-dire sous forme vapeur) est supérieure à 400 mbar. En particulier, la figure 7 montre ce qu'il est possible d'obtenir comme épaisseur en nanomètres pour des réseaux métallo-organique ZIF-8 en fonction de la pression partielle en mbar de l'additif utilisé alors formé par de l'eau sous forme vapeur. Dans le cas de cette figure 7, la couche d'oxyde métallique formée sur le substrat 10 est une couche de ZnO présentant 50 nm d'épaisseur, cette couche d'oxyde métallique étant traitée dans le cadre des résultats de la figure 7 en mettant en œuvre, pour différentes pressions partielles de l'additif, un seul cycle en phase vapeur avec du 2-méthylimidazole en tant que ligand et avec de l'eau en tant qu'additif ; ce cycle en phase vapeur regroupe donc l'étape de traitement avec le ligand et l'étape de traitement avec l'additif et ce cycle en phase vapeur est dans le cas présent réalisé à environ 103°C. Cette figure 7 permet de montrer que, dans le but d'obtenir une épaisseur de réseau métallo-organique ZIF-8 supérieure à 20 nm par cycle de réaction, il est préférable que la pression partielle de l'additif soit supérieure à 400 mbar. En effet, la lecture de la figure 7 permet de déduire que les épaisseurs de réseaux métallo-organique 5 sont plus importantes entre 400 mbar et 600 mbar de pression partielle pour l'additif lorsque l'additif est de l'eau sous forme vapeur. La figure 7 permet de déterminer les épaisseurs de réseaux métallo-organique ZIF-8 qui peuvent être atteintes lors de la mise en œuvre du premier cycle de réaction de la pluralité de cycles de réaction P, tout en sachant que bien entendu, dans le cadre du procédé de formation tel que décrit, un ou plusieurs autres cycles identiques à ce premier cycle suivent ce premier cycle afin d'augmenter l'épaisseur du réseau métallo-organique 5 notamment de cycle en cycle. Bien entendu, cette manipulation a été réalisée pour le ZIF-8, mais peut être généralisée à tout autre ZIF.

La température du substrat 10 et/ou de l'additif pendant cette étape peut être comprise et/ou maintenue entre 80°C et 180°C et notamment à 100°C ou 110°C. Généralement, la température du substrat n'est pas modifiée entre les étapes de traitement par un ligand P1 et l'étape de traitement avec un additif P2.

Les figures 3 et 4 montrent en outre que l'épaisseur de réseau métallo-organique obtenue est sensiblement proportionnelle au nombre de fois où le cycle P est mis en œuvre. On remarque une augmentation de l'épaisseur en fonction du nombre de cycles qui évolue en première approximation de façon linéaire et sans atteindre apparemment de plateau. Cela indique que la réalisation de cycles supplémentaires permettrait d'obtenir des épaisseurs encore plus importantes, ce qui est inédit pour la synthèse par voie gazeuse.

Plus particulièrement, la figure 3 montre qu'une température de substrat de 100 °C permet l'obtention d'un réseau métallo-organique plus épais que pour 110°C.

La figure 4 montre également que lorsque le ligand est accompagné d'un gaz porteur comme le cas P1b, cela permet d'obtenir une épaisseur du réseau métallo-organique plus importante que sans gaz porteur comme le cas P1a. Ainsi, au bout de 20 cycles, l'épaisseur du réseau métallo-organique peut dépasser 250 nanomètres ce qui est avantageux pour augmenter l'efficacité du réseau métallo-organique une fois formé dans les dispositifs de détection ou pour mieux filtrer les gaz par exemple.

Il est possible de générer ou modifier une porosité ou un caractère hydrophobe du réseau métallo-organique en changeant la nature de la couche d'oxyde métallique et/ou du ligand et/ou de l'additif ainsi que leurs pressions partielles respectives.

Comme illustré sur la figure 2, selon une variante de mise en œuvre du procédé, au moins un des cycles de la pluralité de cycles de réaction P comprend au moins une étape de purge P0. Cette étape de purge P0 peut consister en une mise sous vide ou une fourniture de gaz neutre. L'étape de purge P0 est effectuée avant et/ou après l'étape de traitement avec un ligand P1. Une hypothèse est que cela permet notamment d'interagir avec les pores du réseau métallo-organique créés aux cycles précédents pour par exemple les vider des produits, comme les oxydants, n'ayant pas réagis auparavant.

L'étape de purge P0 peut durer entre quelques secondes et 30 minutes et notamment 10 minutes.

La mise sous vide et/ou la fourniture de gaz neutre s'appliquent à au moins une des portions additionnelles du réseau métallo-organique obtenues à l'étape de traitement avec un ligand P1 de chaque cycle de réaction P ou à la couche d'oxyde métallique ou de manière équivalente sa portion restante.

Dans une mise en œuvre du procédé, l'étape de traitement avec un additif P2 se fait séquentiellement. Selon une variante de réalisation, l'étape de traitement avec un additif P2 se déroule au moins en partie pendant l'étape de traitement avec un ligand P1.

La répétition du cycle P a pour effet surprenant d'augmenter l'épaisseur du réseau métallo organique, et ce sans ajout intermédiaire de couche d'oxyde métallique. Cela est avantageux car contrairement aux méthodes où une couche d'oxyde métallique est déposée à chaque cycle, une portion restante de la couche d'oxyde métallique ne vient pas bloquer le passage des réactifs comme le ligand et/ou l'additif vers la partie de la couche d'oxyde métallique n'ayant pas encore réagie.

Dans une mise en œuvre du procédé, les cycles de réaction P sont répétés jusqu'à ce que la couche d'oxyde métallique soit entièrement transformée en réseau métallo-organique. Cela permet avantageusement d'obtenir un réseau métallo-organique présentant une épaisseur supérieure à 250 nanomètres.

Dans une mise en œuvre particulière du procédé de fabrication du réseau métallo-organique, une étape d'activation intervenant à la fin du procédé, permet d'éliminer les potentiels résidus dans les pores du réseau métallo-organique formé. Cela a pour avantage de pouvoir réaliser l'adsorption de molécules dans la porosité ouverte du réseau. Cette étape d'activation consiste à chauffer l'ensemble constitué par le substrat et le réseau métallo-organique sous vide ou sous atmosphère inerte à des températures comprises entre 50 à 300 °C, ou bien à l'immerger dans un solvant, tel que le méthanol, à température comprise entre l'ambiante et le point d'ébullition.

Un avantage de l'étape d'activation et/ou des étapes de purge tient en ce que le passage éventuel d'un gaz ou d'un liquide à travers des pores du réseau métallo-organique est amélioré pour atteindre la partie de la couche d'oxyde métallique n'ayant pas encore été transformée en partie du réseau métallo-organique.

Le procédé peut être appliqué par exemple pour l'intégration du réseau métallo-organique dans des dispositifs de détection ou de préconcentration de gaz, dans les systèmes électromécaniques nano/micrométriques appelés en anglais NEMS ou MEMS, dans les purificateurs d'air, dans les membranes de séparation de gaz et couches minces diélectriques. Il est également envisageable d'utiliser ce procédé dans la fabrication des processeurs ou des capteurs.

Un autre aspect de l'invention est le réseau métallo-organique 5 formé par l'application d'un tel procédé à partir d'une seule couche d'oxyde métallique obtenue sur le substrat 10. Le réseau métallo-organique 5 ainsi formé est constitué d'une seule couche monolithique métallo-organique et non d'une pluralité de couches intermédiaires avec peu de liaisons chimiques entre elles et montrant la présence de multiples interfaces fragilisées comme cela pourrait être le cas pour les méthodes mettant en œuvre une nouvelle couche d'oxyde métallique à chaque cycle.

Dans un exemple, la couche monolithique composant le réseau métallo-organique est complétée par la portion restante de la couche d'oxyde métallique qui n'a pas été consommée. Cela diffère des méthodes où un dépôt d'oxyde métallique est réalisé à chaque cycle puisque dans ces méthodes il peut exister autant de portions restantes de couches d'oxyde métallique que de nombre de cycles.

Dans un exemple, il est possible d'obtenir un réseau métallo-organique ayant une épaisseur supérieure à 250 nanomètres. Une telle épaisseur ne semble pas pouvoir être obtenue par les autres méthodes connues de la personne du métier mettant en œuvre des gaz selon des méthodes de la microélectronique. En effet, les autres méthodes ne réalisent pas d'étape de traitement avec un ligand puis un traitement avec un additif P2 de façon cyclique c'est-à-dire de façon répétée et successive sans ajout d'une couche d'oxyde métallique entre chaque cycle de réaction. Une telle étape permet d'interagir avec les pores et la surface du réseau métallo-organique et/ou avec la portion de la couche d'oxyde métallique restante pour favoriser la croissance du réseau métallo-organique.

Ainsi, le réseau métallo-organique 5 peut être formé par la mise en œuvre du procédé de formation tel que décrit précédemment de sorte que le réseau métallo-organique 5 formé sur le substrat 10 se présente sous la forme d'une seule couche monolithique ne présentant pas de strates, ce réseau métallo-organique 5 ayant une épaisseur supérieure à 250 nm et, par exemple, inférieure à 5 µm.

## Revendications

1. Procédé de formation d'un réseau métallo-organique (5) comprenant :
- une étape de fourniture d'un substrat (10) ;
- une unique étape de formation (20) d'une seule couche d'oxyde métallique formée sur le substrat (10), ladite couche d'oxyde métallique étant transformée en tout ou partie en réseau métallo-organique (5) par mise en œuvre successive d'une pluralité de cycles de réaction (P) ; chaque cycle de réaction (P) de la pluralité de cycles de réaction comportant :
une étape de traitement avec au moins un ligand (P1) ;
une étape de traitement avec au moins un additif (P2) ;
les cycles de réaction (P) étant mis en œuvre au moins deux fois de manière à former le réseau métallo-organique (5) sur le substrat (10).

2. Procédé de formation d'un réseau métallo-organique selon la revendication 1, dans lequel le cycle de réaction (P) comprend une étape de purge (P0) consistant en une mise sous vide et/ou une fourniture de gaz neutre ; l'étape de purge (P0) étant effectuée avant et/ou après l'étape de traitement avec un ligand (P1).

3. Procédé de formation d'un réseau métallo-organique selon l'une quelconque des revendications précédentes, dans lequel l'étape de traitement avec un additif (P2) se déroule au moins en partie pendant l'étape de traitement avec un ligand (P1).

4. Procédé de formation d'un réseau métallo-organique selon l'une quelconque des revendications précédentes, dans lequel l'oxyde métallique est un oxyde de zinc, un oxyde de cobalt, un oxyde de cuivre, un oxyde de fer ou un oxyde d'indium.

5. Procédé de formation d'un réseau métallo-organique selon l'une quelconque des revendications précédentes, dans lequel les cycles de réaction (P) sont répétés jusqu'à ce que la couche d'oxyde métallique soit entièrement transformée en réseau métallo-organique.

6. Procédé de formation d'un réseau métallo-organique selon l'une quelconque des revendications précédentes, dans lequel l'additif est de l'eau ou un alcool ou un polyol ou une combinaison de ces additifs ou un réactif destiné à former au moins l'un de ces additifs lors du cycle de réaction (P).

7. Procédé de formation d'un réseau métallo-organique selon l'une quelconque des revendications précédentes, dans lequel, le substrat et/ou ledit ligand et/ou ledit additif, est maintenu à une température comprise entre 80°C et 180°C durant le cycle de réaction (P).

8. Procédé de formation d'un réseau métallo-organique selon l'une quelconque des revendications précédentes dans lequel, dans l'étape de traitement avec un ligand (P1), ledit au moins un ligand est en phase liquide ou en phase vapeur ; et dans lequel, dans l'étape de traitement avec un additif (P2), ledit additif est en phase liquide ou en phase vapeur.

9. Procédé de formation d'un réseau métallo-organique selon la revendication précédente, dans lequel le ligand est en phase vapeur et pendant l'étape de traitement avec un ligand (P1), ledit au moins un ligand est mélangé à au moins un gaz porteur appartenant au groupe comprenant le diazote, l'hélium et l'argon.

10. Procédé de formation d'un réseau métallo-organique selon la revendication 9, dans lequel ledit au moins un ligand est à une pression partielle comprise entre 0,1 mbar et 50 mbar, de préférence entre 14 mbar et 35 mbar.

11. Procédé de formation d'un réseau métallo-organique selon l'une quelconque des revendications 8 à 10, dans lequel, dans l'étape de traitement avec un additif (P2), ledit au moins un additif est en phase vapeur et est mélangé à au moins un gaz porteur appartenant au groupe comprenant le diazote, l'hélium et l'argon.

12. Procédé de formation d'un réseau métallo-organique selon la revendication 11, dans lequel ledit au moins un additif est à une pression partielle comprise entre 1 mbar et 900 mbar, plus particulièrement entre 200 mbar et 600 mbar, et, de préférence, supérieure à 400 mbar.

13. Procédé de formation d'un réseau métallo-organique selon l'une quelconque des revendications 1 à 12, dans lequel le procédé comprend une étape d'activation dans laquelle des pores ouverts du réseau métallo-organique sont rendus accessibles pour l'adsorption de molécules par un traitement thermique effectué sous vide dynamique, sous un flux de gaz neutre, ou par immersion dans un solvant.

14. Procédé de formation d'un réseau métallo-organique selon la revendication 13, dans lequel la couche d'oxyde métallique, avant la mise en œuvre des cycles de réaction (P), a une épaisseur supérieure à 18 nanomètres et est composée d'oxyde de zinc ; dans lequel le ligand utilisé dans l'étape de traitement par un ligand (P1) est du 2-méthylimidazole ; dans lequel l'additif utilisé dans l'étape de traitement par un additif (P2) est de l'eau, dans lequel le cycle de réaction (P) est répété au moins quinze fois ; et dans lequel l'étape d'activation consiste en un traitement thermique jusqu'à 280°C sous diazote.

15. Réseau métallo-organique (5) formé par la mise en œuvre d'un procédé selon l'une des revendications précédentes, le réseau métallo-organique (5) formé sur le substrat (10) se présentant sous la forme d'une seule couche monolithique ne présentant pas de strates.

16. Réseau métallo-organique (5), dans lequel le réseau métallo-organique (5) a une épaisseur supérieure à 250 nm.
